# EUROPEAN PATENT APPLICATION

(11) **EP 2 161 747 A1**
(43) Date of publication of application: **10.03.2010**
(21) Application number: 08163705.0
(22) Date of filing: 04.09.2008
(51) Int. Cl.: H01L 23/498, H01L 23/538

(54) **Electronic component package and method of manufacturing the same**

(71) Applicant: Shinko Electric Industries Co., Ltd., Nagano-shi, Nagano 381-2287 (JP)
(72) Inventor: Shimizu, Hiroshi, Shinko Electric Industries co., Ltd., Nagano-shi, Nagano 381-2287 (JP); Kato, Hiroyuki, Shinko Electric industries co., Ltd., Nagano 381-2287 (JP); Takenouchi, Takahiro, Shinko Electric industries co., Ltd., Nagano 381-2287 (JP)
(74) Representative: Zimmermann & Partner

(57) **Abstract**

There is provided an electronic component package (10). The electronic component package includes: a core layer (11) including a plurality of insulating layers formed by impregnating a base material with a resin, wherein a hollow portion is formed in the core layer; core wiring layers (12a, 12b) each disposed between the insulating layers; and an electronic component disposed in the hollow portion. The electronic component and the core wiring layer are electrically connected to each other by a bonding wire.

## Description

### BACKGROUND OF THE INVENTION

### Technical Field

The present disclosure relates to an electronic component package and a method of manufacturing the same. More particularly, the present disclosure relates to an electronic component package having a small thickness to which an electronic component is securely electrically connected and a method of manufacturing the same.

### Related Art

In the related art, an electronic component package having an electronic component such as a semiconductor chip mounted thereon has been widely used. In such a kind of electronic package, an electronic component is mounted, and a wiring board has a multilayered structure to mount circuit components with high density.

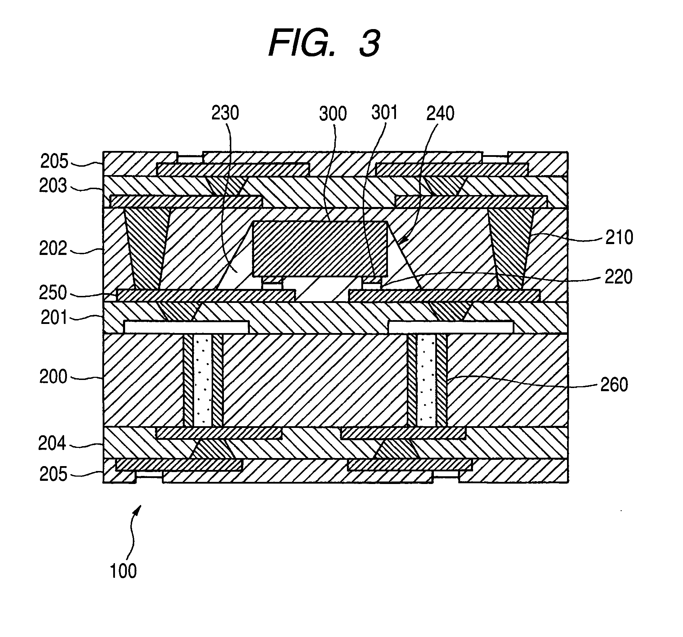

For example, an electronic component package 100 shown in Fig. 3 has a core layer 200 having mechanical strength as a frame of the electronic component package 100, in which insulating layers 201, 202, and 203 are formed on an upper surface of the core layer 200, and an insulating layer 204 is formed a lower surface of the core layer 200. The electronic component package 100 has a multi-layered wiring board structure in which wiring layers are formed between the core layer 200 and the insulating layers and between the insulating layers one another, and an electronic component 300 is disposed in a hollow portion 240 formed in the insulating layer 202 formed on an upper surface of the core layer 200. A gap of the hollow portion 240 for disposing the electronic component 300 is filled with a sealing material 230.
Solder resist layers 205 as insulating layers are formed on an upper surface of the insulating layer 203 and on a lower surface of the insulating layer 204, and is configured to protect the multi-layered wiring board. A through-hole 260 is formed in the core layer 200.

The electronic component 300 has solder bumps 301. The solder bumps 301 of the electronic component 300 are electrically connected to electrode pads 220 formed on a wiring layer 250. As described above, the electronic component 300 is electrically connected to the wiring layer by flip-chip boding.

The flip-chip bonding is a technique frequently used in electronic component packages (*see* e.g., JP-A-2002-290051 and JP-A-2002-246505).

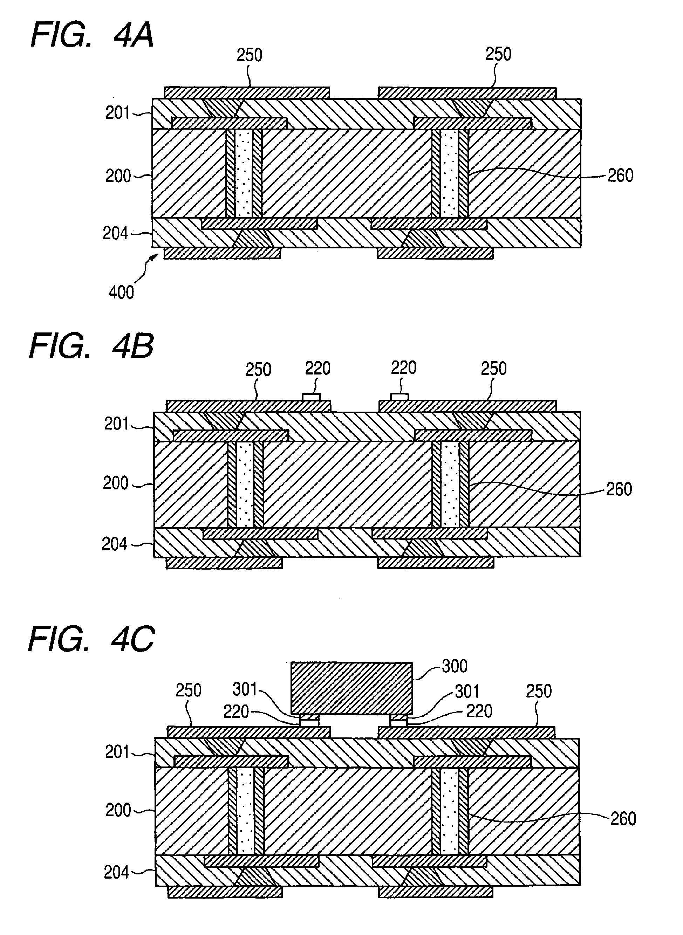

In the method for manufacturing the above-described electronic component package, bonding steps for flip-chip bonding the electronic component 300 and the wiring layer 250 will be described hereinafter with reference to Figs. 4A to 4C.
First, as shown in Fig. 4A, a multi-layered wiring board 400 having a core layer 200, insulating layers, and wiring layers formed therein is formed by the known method.

Then, as shown in Fig. 4B, electrodes 220 are formed on an upper wiring layer 250 of the multi-layered wiring board 400.
Then, as shown in Fig. 4C, the electronic component 300 is disposed on the multi-layered wiring board 400 such that solder bumps 301 come into contact with the electrode pads 220 formed on the wiring layer 250, and then the solder bumps 301 are melted to electrically connect the electronic component 300 to the electrode pads 220.

When the electronic component 300 is disposed on the multi-layered wiring board 400, very high positional accuracy is required. The size of the solder bumps 301 and the electrode pads 220 is very small. Accordingly, when mounting position of the electronic component 300 is deviated, the electronic component 300 is not electrically connected to the multi-layered wiring board 400, and thus the manufactured electronic component package becomes an inferior good. In the example of the flip-chip bonding shown in Figs. 4A to 4C, the electronic component 300 is mounted on the multi-layered wiring board 400 with the solder bumps 301 being downward, and thus it is very difficult to check whether or not the electrode pads 220 is satisfactorily connected by melting the solder bumps 301 in the manufacturing process.

In the related art electronic component package shown in Fig. 3, the electronic component 300 is disposed on the core layer 200 having a given thickness. A thickness of the insulating layer 202 for mounting the electronic component 300 is added to the thickness of the core layer 200, thereby increasing the thickness of the electronic component package. For example, the thickness of the insulating layer 202 for mounting the electronic component 300 may be at least 150 µm.

In the core layer 200 having mechanical strength as a frame of the electronic component package 100, there is a limit in decreasing the thickness thereof. The thickness depends on raw materials for forming the core layer 200. However, when the core layer 200 is formed by impregnating a glass cross with epoxy resin, the thickness of the core layer 200 may be at least 200 µm.
As a result, the total thickness of the thickness of the core layer 200 and the thickness of the insulating layer 202 for mounting the electronic component 300 may be at least 350 µm, and thus there is a problem that the electronic component package becomes thick.

In the electronic component package shown in Fig. 3, since the thickness of the insulating layer 202 may be at least 150 µm as described above, an aspect ratio of a via 210 formed to pass through the insulating layer 202 becomes high and thus the via 210 has a long and thin shape.

In the case of a via having a high aspect ratio, a plating solution may not evenly get to the whole inside of a via-hole, for example, when a plating process is performed on the via. Accordingly, the via may be disconnected.

### SUMMARY OF THE INVENTION

Exemplary embodiments of the present invention address the above disadvantages and other disadvantages not described above. However, the present invention is not required to overcome the disadvantages described above, and thus, an exemplary embodiment of the present invention may not overcome any of the problems described above.
In light of the above, the electronic component package according to independent claim 1, and the method according to independent claim 7 are provided.
Further advantages, features, aspects and details are evident from the dependent claims 2 to 6, the description and the drawings.

It is an aspect of the present invention to provide an electronic component having a small thickness to which an electronic component is securely electrically connected, and a method for manufacturing the same.

According to one or more aspects of the present invention, there is provided an electronic component package. The electronic component package includes:
a core layer including a plurality of insulating layers formed by impregnating a base material with a resin, wherein a hollow portion is formed in the core layer;
core wiring layers each disposed between the insulating layers; and
an electronic component disposed in the hollow portion,
wherein the electronic component and the core wiring layer are electrically connected to each other by a bonding wire.

According to one or more aspects of the present invention, the core layer includes:
an insulating core intermediate layer having an intermediate-layer through-hole constituting the hollow portion, wherein the electronic component is housed in the intermediate-layer through-hole;
an insulating core lower layer disposed on a lower surface of the insulating core intermediate layer, wherein the electronic component is bonded onto the insulating core lower layer; and
an insulating core upper layer disposed on an upper surface of the insulating core intermediate layer and having an upper-layer though-hole constituting the hollow portion together with the intermediate-layer through-hole,
wherein the core wiring layers includes:
   an upper core wiring layer formed on the upper surface of the insulating core intermediate layer; and
   an lower core wiring layer formed on the lower surface of the insulating core intermediate layer,
wherein the upper-layer through-hole is larger than the intermediate-layer through-hole, and
wherein the electronic component are electrically connected to the upper core wiring layer exposed from the insulating core upper layer, by the bonding wire.

According to one or more aspects of the present invention, the insulating core intermediate layer includes: a via passing through the core intermediate layer, wherein the upper core wiring layer and the lower core wiring layer are electrically connected to each other by the via, and wherein an aspect ratio of the via is 1 or less.

According to one or more aspects of the present invention, the hollow portion in which the electronic component is disposed is filled with a sealing material.

According to one or more aspects of the present invention, at least one wiring board is formed on an upper surface of the core layer or a lower surface of the core layer.

According to one or more aspects of the present invention, the base material is made of a glass cross, and the resin is an epoxy resin.

According to one or more aspects of the present invention, there is provided a method of manufacturing an electronic component package. The method inlcudes:
(a) providing a first insulating layer formed by impregnating a base material with a resin;
(b) forming conductive layers on upper and lower surfaces of the first insulating layer;
(c) forming a through-hole in the first insulating layer;
(d) forming a via in the through-hole;
(e) forming wiring patterns on the conductive layer formed on the upper surface of the first insulating layer;
(f) forming a first opening in the first insulating layer;
(g) patterning the conductive layers, thereby forming wiring layers;
(h) forming a second insulating layer, formed by impregnating a base material with a resin, on the upper surface of the first insulating layer;
(i) forming a second opening in the second insulating layer such that the second opening is larger than the first opening and such that a center of the second opening coincides with that of the first opening;
(j) forming a third insulating layer, formed by impregnating a base material with a resin, on the lower surface of the first insulating layer;
(k) heating and pressurizing the first insulating layer, the second insulating layer and the third insulating layer, thereby integrating the first insulating layer, the second insulating layer and the third insulating layer;
(l) housing an electronic component in the first opening such that the electronic component is mounted on the third insulating layer exposed from the second insulating layer; and
(m) electrically connecting the electronic component to the wiring layer formed on the upper surface of the first insulating layer, by a bonding wire.

According to the present invention, the electronic component package has a small thickness to which the electronic component is securely electrically connected.
According to the method for manufacturing the electronic component package of the invention, it is possible to manufacture the electronic component package having a small thickness to which the electronic component is securely electrically connected.
Embodiments are also directed to apparatuses for carrying out the disclosed methods and including apparatus parts for performing described method steps. Furthermore, embodiments are also directed to methods by which the described apparatus operates or by which the described apparatus is manufactured. It may include method steps for carrying out functions of the apparatus or manufacturing parts of the apparatus. The method steps may be performed by way of hardware components, firmware, software, a computer programmed by appropriate software, by any combination thereof or in any other manner.

Other aspects and advantages of the present invention will be apparent from the following description, the drawings, and the claims.

### BRIEF DESCRIPTION OF THE DRAWINGS

The above and other aspects, features and advantages of the present invention will be more apparent from the following more particular description thereof, presented in conjunction with the following drawings. So that the manner in which the above recited features of the present invention can be understood in detail, a more particular description of the invention, briefly summarized above, may be had by reference to embodiments. The accompanying drawings relate to embodiments of the invention and are described in the following:
Fig. 1 is a sectional view illustrating an electronic component package according to an exemplary embodiment of the present invention;
Figs. 2A to 2K are views illustrating an exemplary embodiment of a method of manufacturing the electronic component package shown in Fig. 1;
Fig. 3 is a sectional view illustrating an electronic component package in the related art; and
Figs. 4A to 4C are views illustrating a main part in a method of manufacturing the electronic component package shown in Fig. 3.

### DETAILED DESCRIPTION OF EXEMPLARY EMBODIMENTS OF THE PRESENT INVENTION

Exemplary embodiments of the present invention will be described with reference to the drawings hereinafter.

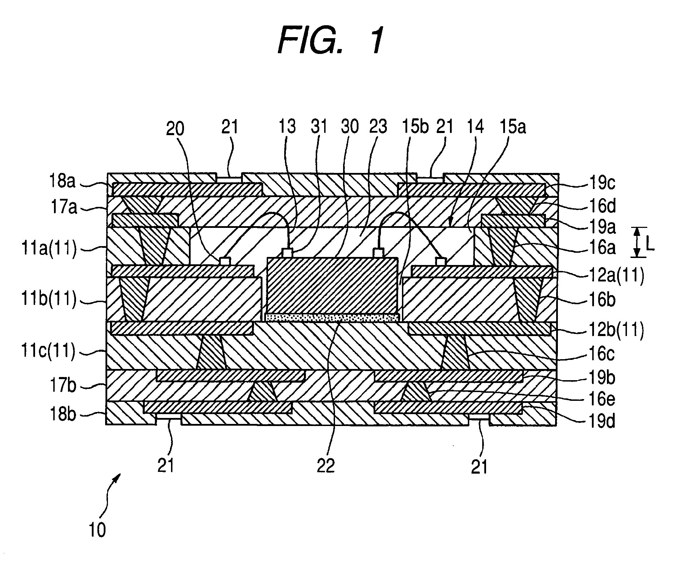

As shown in Fig. 1, an electronic component package 10 of the present embodiment includes a core layer 11 formed by laminating a core upper layer 11 a, a core intermediate layer 11b, and a core lower layer 11c, which are formed by impregnating a substrate with resin; core wiring boards 12a and 12b disposed between the insulating layers forming the core layer 11; and an electronic component 30 disposed in a hollow portion 14 formed in the core layer 11. The electronic component 30 and the core wiring board 12a are electrically connected to each other by bonding wires 13. Fig. 1 is a sectional view illustrating the electronic component package 10.

In the electronic component package 10 of the present embodiment, as shown in Fig.1, the core layer 11 is formed by laminating the core intermediate layer 11b having an intermediate-layer through-hole 15b forming the hollow portion 14, the core lower layer 11c disposed on a lower surface of the core intermediate layer 11b and formed to fix the electronic component 30 thereto, and the core upper layer 11a disposed on an upper surface of the core intermediate layer 11b and having an upper-layer through-hole 15a forming the hollow portion 14 together with the intermediate-layer through-hole 15b.

In this Specification, a side close to the core upper layer 11a of the core layer 11 is called as an upside of the core layer 11, and the opposite side is called as a downside of the core layer 11. A side close to the upside of the core layer 11 is called as an upside of the electronic package 10, and the opposite side is called as a downside of the electronic component package 10.

The core layer 11 has high rigidity, and has mechanical strength as a frame of the electronic component package 10. Each of the core upper layer 11 a, the core intermediate layer 11b, and the core lower layer 11c has an electrical insulating property (hereinafter, referred to as an insulating property), and insulates the wiring layer from the other wiring layer.

The insulating core upper layer 11a, core intermediate layer 11b, and core lower layer 11c are made of preferably a material having high rigidity and good workability. In the present embodiment, each of the core upper layer 11a, the core intermediate layer 11b, and the core lower layer 11c is formed by impregnating a substrate formed of a glass cross with thermosetting epoxy resin.

In the present embodiment, an upper core wiring layer 12a having a predetermined pattern is disposed between the core upper layer 11a and the core intermediate layer 11b. Similarly, a lower core wiring layer 12b having a predetermined pattern is disposed between the core lower layer 11c and the core intermediate layer 11b. The upper core wiring layer 12a and the lower core wiring layer 12b may be formed by the known method such as a copper plating process.

As described above, in the present embodiment, the core layer 11 is formed by laminating the core upper layer 11a, the core intermediate layer 11b, the core lower layer 11c, the upper core wiring layer 12a, and the lower core wiring layer 12b.

The upper-layer through-hole 15a passing through the core upper layer 11a is formed in the core upper layer 11a in a direction perpendicular to a plane direction thereof. The intermediate-layer through-hole 15b passing through the core intermediate layer 11b is formed in the core intermediate layer 11b in a direction perpendicular to a plane direction thereof.

In the present embodiment, the upper-layer through-hole 15a is formed larger than the intermediate-layer through-hole 15b in the plan view. The core upper layer 11 a and the core intermediate layer 11b are laminated in such a state that the center of the upper-layer through-hole 15a substantially coincides with the center of the intermediate-layer through-hole 15b in the plan view.

As shown in Fig. 1, a through-hole coinciding in position and size with the intermediate-layer through-hole 15b is formed in the core wiring layer 12a.

The hollow portion 14 is formed by coupling the upper-layer through-hole 15a and the intermediate-layer through-hole 15b.
The hollow portion 14 is a concave portion having an opening toward the core upper layer 11a in the core layer 11. As shown in Fig. 1, in the hollow portion 14, the size of a part of the core upper layer 11a is larger than that of a part of the core intermediate layer 11b. The hollow portion 14 has a stepwise shape in the sectional view.

The intermediate-layer through-hole 15b forming the downside of the hollow portion 14 is set to have a shape that can house the electronic component 30 in consideration of the shape and size of the electronic component 30 mounted therein. Since the electronic component 30 mounted in the electronic component package 10 is rectangular in the plan view, the intermediate-layer through-hole 15b is preferably also rectangular in the plan view. However, the shape is not limited thereto, and may be circular or polygonal in addition to rectangular.

In the present embodiment, the electronic component 30 is rectangular in the plan view, and the intermediate-layer through-hole 15b and the upper-layer through-hole 15a are also rectangular.

The electronic component 30 is inserted into the intermediate-layer through-hole 15b such that the upper surface on which terminals 31 thereof are formed is toward the opening side of the hollow portion 14. The lower surface thereof is adhered and fixed to the upper face of the core lower layer 11c through an adhesive layer 22.

The upper end of the upside on which the terminals 31 of the electronic component 30 are formed extends upward from the upper surface of the core intermediate layer 11b, and is located within the upper-layer through-hole 15a.
It is advantageous that the upper surface of the electronic component 30 does not protrude from the upper surface of the core upper layer 11a, in housing the electronic component 30 in the core layer 11.

For example, the electronic component 30 may be a semiconductor chip, a capacitor, a resistor, an inductor, or the like.
The adhesive layer 22 may be formed by using an adhesive sheet or by coating an adhesive. For example, a die attach film may be used as the adhesive sheet.

As shown in Fig. 1, in the electronic component package 10 of the present embodiment, a part of the core intermediate layer 11b near the intermediate-layer through-hole 15b together with the upper core wiring layer 12a extends from the right and left of the upper-layer through-hole 15a toward the inside of the upper-layer through-hole 15a in a layer direction. The extending part of the core wiring layer 12a and the electronic component 30 are electrically connected to each other by bonding wires 13.

Namely, electrode pads 20 are formed on the extending part of the core wiring layer 12a, and the bonding wires 13 are electrically connected to the upper core wiring layer 12a through the electrode pads 20. The bonding wires 13 are electrically connected to the terminals 31 of the electronic component 30, respectively. The electrode pads 20 may be formed, for example, by NiAu plating.

A diameter of the bonding wires 13 is substantially in the range of 15 to 25 µm, the electrode pads 20 and the terminals 31 connected to the bonding wires 13 have sizes suitable to connect the bonding wires 13, which are very small. Parts of the core wiring layer 12a on which electrode pads 20 are formed have substantially the same size as that of the electrode pads 20, and formed by thin wiring patterns.

In the present embodiment, a gap of the hollow portion 14 in which the electronic component 30 is disposed is filled with a sealing resin 23 as a sealing material, which fixes the electronic component 30 to the core layer 11. The sealing resin 23 may be formed of the known material such as a resin material used for potting of an electronic component package.

A via 16b passing through the core intermediate layer 11b is formed in the core layer 11 of the electronic component package 10, and the upper core wiring layer 12a and the lower core wiring layer 12b are electrically connected to each other by the via 16b. An aspect ratio of the via 16b is preferably 1 or less. When the aspect ratio of the via 16b is higher than 1 and the via 16b is long and thin, discontinuity may occur in a conductive material at the time when the via is filled with the conductive material by a plating process, and thus disconnection may occur in the via.

In the present embodiment, a via-hole is formed by a laser process. In the via-hole, a diameter of the via-hole on one side to which a laser beam is incident is larger than a diameter of the via-hole on the other side. The aspect ratio of the via 16b having such an asymmetric shape is calculated from an average diameter of via 16b and a length of the via 16b. The same may be applied to the other via of the electronic component package 10.

A via 16a passing through the core upper layer 11a is formed in the core upper layer 11a, and a wiring layer 19a disposed on the upside of the core upper layer 11 a and the core wiring layer 12a are electrically connected to each other by the via 16a. A via 16c passing through the core lower layer 11c is formed in the core lower layer 11c, and the wring layer 19b disposed on the downside of the core lower layer 11c and the lower core wiring layer 12b are electrically connected to each other by the via 16c.

In the electronic component package 10 of the present embodiment, a plurality of wiring boards are laminated on an upper surface and a lower surface of the core layer 11. Specifically, a multi-layered wiring board formed by laminating the wiring layer 19a, an insulating layer 17a, and a wiring layer 19c in order from the downside is laminated on the upper surface of the core layer 11. A multi-layered wiring board formed by laminating a wiring layer 19d, an insulating layer 17b, and a wiring layer 19b in order from the downside is laminated on the lower surface of the core layer 11.

A via 16d passing through the insulating layer 17a is formed in the insulating layer 17a, and the wiring layer 19c and the wiring layer 19a are electrically connected to each other by the via 16d. Similarly, a via 16e passing through the insulating layer 17b is formed in the insulating layer 17b, and the wiring layer 19b and the wiring layer 19d are electrically connected to each other by the via 16e.

The insulating layers 17a and 17b may be formed of insulating materials such as epoxy resin. The wiring layers 19a, 19b, 19c, and 19d may be formed by the known method such as a copper plating process.

A solder resist layer 18a is formed on the insulating layer 17a and the wiring layer 19c such that given portions serving as an external connection terminal 21 on the wiring layer 19c are exposed. Similarly, a solder resist layer 18b is formed on the insulating layer 17b and the wiring layer 19d such that given portions serving as another external connection terminal 21 on the wiring layer 19d are exposed.

The external connection terminals 21 are formed at the portions of the wiring layers 19c and 19d exposed from the solder resist layers 18a and 18b by a plating process such as an NiAu plating process.
The external connection terminals 21 can be electrically connected to semiconductor devices and another electronic component package. In addition, the external connection terminals 21 may be electrically connected to an external voltage terminal or a ground terminal.

Next, a size of each part of the above-described electronic component package 10 will be described hereinafter.
The total thickness of the core upper layer 11a, the core intermediate layer 11b, and the core lower layer 11c is preferably 100 µm or more in securing rigidity of the electronic component package 10 to prevent deformation such as bending.
The core upper layer 11a, the core intermediate layer 11b, and the core lower layer 11c have preferably thicknesses so that the aspect ratio of the via formed on each layer is 1 or less, respectively. For example, when a via-hole is formed by a laser process, the thickness is preferably equal to or smaller than the diameter of the laser beam. Specifically, when the diameter of the laser is about 80 µm, each thickness of the core upper layer 11a, the core intermediate layer 11b, and the core lower layer 11c is preferably 80 µm or less.
The lower limit of the thickness of the layers is set preferably by rigidity necessary for the electronic component package 10. The thicknesses of the core upper layer 11a and the core intermediate layer 11b are set preferably by relation with the size of the electronic component 30.

A length L (*see* Fig. 1) from the upper face of the electronic component 30 to the upper face of the core upper layer 11a is preferably 60 µm or more, and more preferably 80 µm, in securing a space of positioning loops of the bonding wires 13. Accordingly, thicknesses of the core upper layer 11a and the core intermediate layer 11b are set preferably so that the length L falls within the aforementioned range.
As shown in Fig. 1, a part of the bonding wires 13 may reach the insulating layer 17a adjacent to the upside of the core upper layer 11a.

Each thickness of the upper core wiring layer 12a and the lower core wiring layer 12b laminated on the core layer 11 is generally in the range of 15 to 20 µm. Accordingly, the total thickness of the core upper layer 11a, the core intermediate layer 11b, the core lower layer 11c, the upper core wiring layer 12a, and the lower core wiring layer 12b, which meet the aforementioned thicknesses may be at most 200 µm, when the thickness of the electronic component 30 is 80 µm or less.

It is advantageous that the size of the loops of the bonding wires 13 is small from the viewpoint of reducing the thickness of the hollow portion 14, and further, reducing the thickness of the electronic component package 10. As a method for reducing the size of the loops of the bonding wires 13, for example, a low-loop type wire bonding technique may be used. The height of loops of wires can be 100 µm or less by using the low-roof type wire bonding technique.

According to the electronic component package 10 of the above-described embodiment, the electronic component 30 is disposed in the core layer 11, and the upper core wiring layer 12a and the lower core wiring layer 12b are disposed in the core layer 11. Accordingly, it is possible to make the thickness of the electronic component package 10 small. In addition, the electronic component 30 disposed in the core layer 11 having high rigidity and low deformity is protected by the core layer 11.

The upper core wiring layer 12a and the lower core wiring layer 12b are interposed between the core intermediate layer 11b and the core upper layer 11a and between the core intermediate layer 11b and the core lower layer 11c, which have high rigidity, respectively. Accordingly, the upper core wiring layer 12a and the lower core wiring layer 12b are prevented from deforming. For this reason, even when the wiring pattern having thin lines is formed on the upper core wiring layer 12a or the lower core wiring layer 12b as forming the electrode pads 20, disconnection caused by deformation of the wiring pattern is prevented. Since the parts of the upper core wiring layer 12a on which the electrodes 20 are formed are laminated on the core intermediate layer 11b, disconnection is also prevented.

Since the electronic component 30 is electrically connected to the upper core wiring layer 12a having low deformity by the bonding wires 13, reliability in electrical connection between the electronic component 30 and the wiring layer 12a is high.

Since the vias 16a and 16b formed to pass through the core upper layer 11a and the core intermediate layer 11b, on which the electronic component 30 is mounted, have high aspect ratios, disconnection hardly occurs.

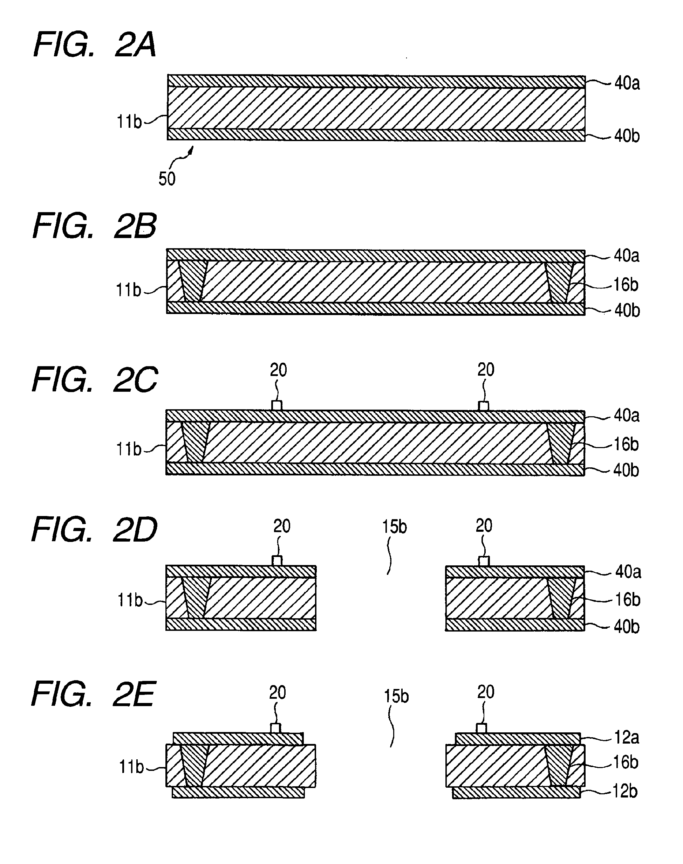

Subsequently, an example of a method of manufacturing the above-described electronic component package of the present invention will be described with reference to Figs. 2A to 2K, hereinafter.

First, as shown in Fig. 2A, there is prepared a core complex 50 in which the conductive layers 40a and 40b are formed on both faces of the core intermediate layer 11b having an electrical insulating property and a plate shape. The core complex 50 may be formed by the known method. The core intermediate layer 11b may be formed in a plate shape by impregnating a substrate made of a glass cross with thermosetting epoxy resin. The conductive layers 40a and 40b may be formed by forming films on the core intermediate layer 11b by sputtering or copper plating. Copper foils may be laminated the core intermediate layer 11b.

Then, a via-hole is formed in the core intermediate layer 11b by a laser process. In an example shown in Fig. 2B, since a laser beam is incident from the conductive layer 40a side, the via-holes are formed in an asymmetry shape in which a diameter close to the conductive layer 40a is large.
A drill process may be used as a method for forming the via-holes, in addition to the laser process.

Then, the via-hole formed as described above is subjected to a plating process such as a copper plating process to form a via 16b. The via 16b is configured to pass through the core intermediate layer 11b and the conductive layers 40a and 40b.

Then, as shown in Fig. 2C, electrode pads 20 are formed on the conductive layer 40a by a plating process. For example, an NiAu plating process may be used as the plating process.

Then, as shown in Fig. 2D, the intermediate-layer through-hole 15b is formed in the core intermediate layer 11b. The intermediate-layer through-hole 15b may be formed at a predetermined position by using a device such as a router. It is advantageous that the shape of the intermediate-layer through-hole 15b is set to house the electronic component 30, in consideration of shape and size of the electronic component 30 mounted therein. In the present embodiment, the electronic component 30 is rectangular in the plan view, and the intermediate-layer through-hole 15b is also rectangular in the plan view.

Then, as shown in Fig. 2E, a given pattern is formed on the conductive layer 40a to form the upper core wiring layer 12a. Specifically, a photosensitive resist is applied onto the surface of the conductive layer 40a, the photosensitive resist is exposed and developed to form a resist pattern, and the exposed part of the conductive layer 40a having no coating is removed by the resist pattern, thereby forming the upper core wiring layer 12a having a given wiring pattern. In this case, the electrode pads 20 are remained. Similarly, a given pattern is formed on the conductive layer 40b to form the lower core wiring layer 12b.

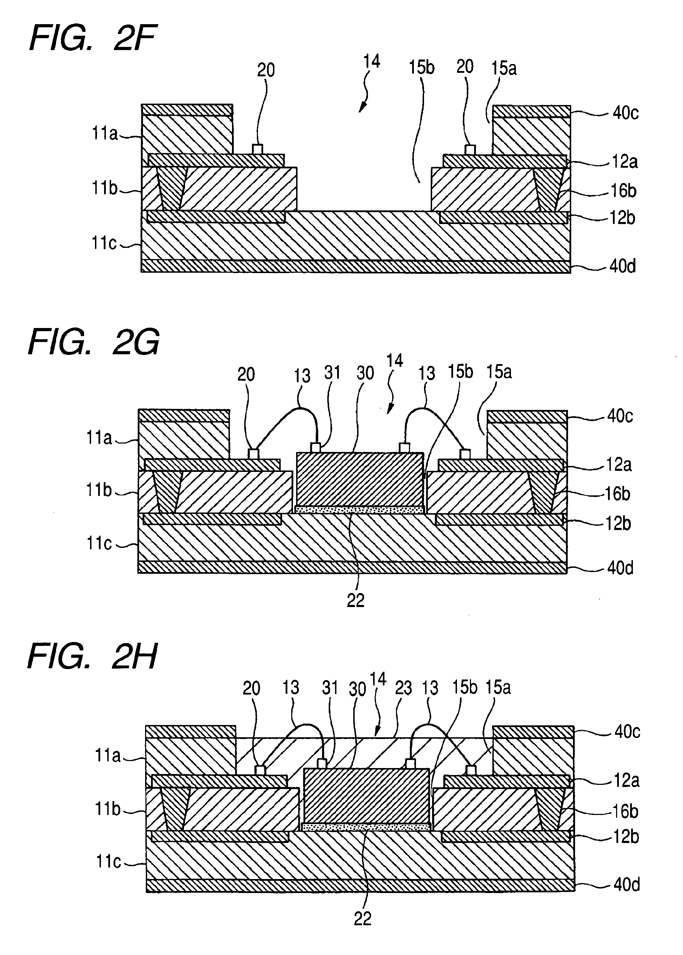

Then, as shown in Fig. 2F, the electrical insulating core upper layer 11 a having one face on which the conductive layer 40c is formed and having the upper-layer through-hole 15a is formed on the core intermediate layer 11b. The core upper layer 11a is formed by impregnating a glass cross as a substrate with thermosetting epoxy resin, and has rigidity suitable to keep a plate shape. However, the core upper layer 11 a is not in a complete thermosetting state yet, and has flexibility. The surface of the core upper layer 11 a has viscosity. The conductive layer 40c may be formed in the same manner as the conductive layers 40a and 40b.

The core upper layer 11a has the upper-layer through-hole 15a having a size larger than that of the intermediate-layer through-hole 15b of the core intermediate layer 11b in the plan view. The upper-layer through-hole 15a is rectangular in the plan view similarly with the intermediate-layer through-hole 15b. The upper-layer through-hole 15a may be formed in the same manner as the intermediate-layer through-hole 15b.

In addition, as shown in Fig. 2F, the core upper layer 11 a is formed on the core intermediate layer 11b with two through-holes 15a and 15b coinciding with each other, so that a part of the wiring pattern of the upper core wiring layer 12a near the intermediate-layer through-hole 15b of the core intermediate layer 11b extends toward the inside of the upper-layer through-hole 15a of the core upper layer 11a in a layer direction. In the present embodiment, the core upper layer 11a is formed on the core intermediate layer 11b such that the center of the upper-layer through-hole 15a coincides with the center of the intermediate-layer through-hole 15b. As a result, as shown in Fig. 2F, a part of the wiring pattern of the upper core wiring layer 12a extends from the right and left of the upper-layer through-hole 15a toward the inside.

Then, the electrical insulating core lower layer 11c having one face on which the conductive layer 40d is formed is formed on a lower surface of the core intermediate layer 11b. The core lower layer 11c is formed by impregnating a glass cross as a substrate with thermosetting epoxy resin, and has rigidity suitable to keep a plate shape. However, the core lower layer 11c is not in a complete thermosetting state yet, and has flexibility. The surface of the core lower layer 11c has viscosity. The conductive layer 40d may be formed in the same manner as the conductive layers 40a and 40b.

Then, the core upper layer 11a, the upper core wiring layer 12a, the core intermediate layer 11b, the lower core wiring layer 12b, and the core lower layer 11c are integrated by heating and pressurizing, thereby to form the core layer 11. The thermosetting epoxy resin forming the core upper layer 11a and the core lower layer 11c is completely hardened by the heating process. As described above, it is advantageous that the core upper layer 11a and the core lower layer 11c serve as adhesive layers by using the epoxy resin in the incomplete thermosetting state, thereby to form the core layer 11.

Then, as shown in Fig. 2G, the adhesive layer 22 is formed on the core lower layer 11c exposed from the intermediate-layer through-hole 15b. The electronic component 30 is inserted into the intermediate-layer through-hole 15b and is disposed in the hollow portion 14 so that the face on which the terminals 31 are formed is toward the opening of the hollow portion 14, and the electronic component 30 is adhered and fixed to the core lower layer 11c through the adhesive layer 22.

Then, the electronic component 30 is electrically connected to a part of the wiring pattern of the upper core wiring layer 12a extending toward the inside of the upper-layer through-hole 15a of the core upper layer 11a, by the bonding wires 13. Specifically, the bonding wires 13 are electrically connected to the parts of the electrode pattern of the upper core wiring layer 12a through the electrode pads 20, respectively. The bonding wires 13 are electrically connected to the terminals 31 of the electronic component 30. The bonding wires 13 are formed preferably by a low-loop type wire bonding technique.

When the electronic component 30 is disposed in the hollow portion 14, positional shift may occur. However, when the wire bonding technique is used, the electrode pads 20 and the terminals 31 can be electrically connected by the bonding wires 13, respectively, in consideration of the position of the electronic component 30 disposed in the hollow portion 14.

Then, it is preferable to check the electrical connection among the bonding wires 13, the electrode pads 20, and the terminals 31 of the electronic component 30. Since the electronic component 30 is disposed such that the terminals 31 are upward and the terminals 31 are exposed, it is easy to check the terminals 31. Similarly, since the electrode pads 20 are formed on the part of the core wiring layer 12a extending toward the inside of the upper-layer through-hole 15a and also the electrode pads 20 are exposed, it is also easy to check the electrode pads 20. At this time, packages having poor connection can be removed.

Then, as shown in Fig. 2H, a gap of the hollow portion 14 in which the electronic component 30 is disposed is filled with a liquid sealing resin 23, and then the sealing resin 23 is hardened. Since the sealing resin 23 is liquid having low viscosity at the time of filling, the hollow portion 14 can be filled with the sealing resin 23 without deformation of the loop shapes of the bonding wires 13.

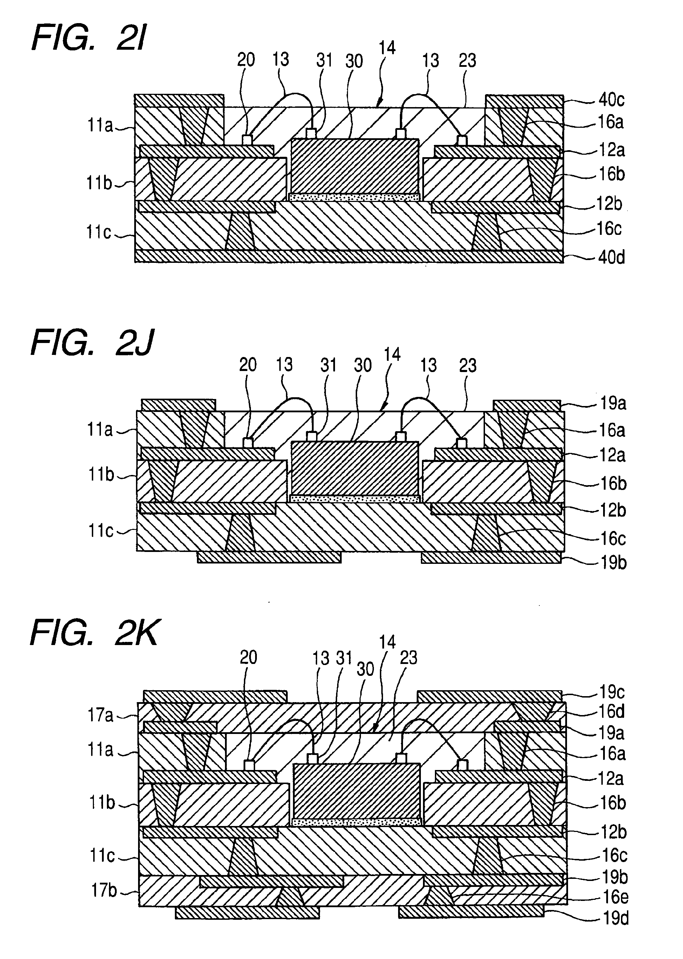

Then, as shown in Fig. 2I, the via 16a is formed to pass through the core upper layer 11a and to electrically connect the conductive layer 40c and the wiring layer 12a to each other. Similarly, the via 16c is formed to pass through the core lower layer 11c and to electrically connect the conductive layer 40d and the wiring layer 12b to each other. The via 16a and the via 16c may be formed in the same manner as the via 16b.

Then, as shown in Fig. 2J, given patterns are formed on the conductive layer 40c and the conductive layer 40d, respectively, thereby forming the wiring layer 19a and the wiring layer 19b. The wiring layer 19a and the wiring layer 19b may be formed in the same manner as the wiring layers 40a and 40b.

Then, the insulating layer 17a is formed on the hollow portion 14 filled with the sealing resin 23, the core upper layer 11a, and the wiring layer 19a. The insulating layer 17a may be formed by laminating a thermosetting resin sheet, or by applying a thermosetting resin solution and then heating and hardening the solution. When the thermosetting resin solution is applied, the bonding wires 13 may be buried in the insulating layer 17a, as shown in Fig. 2K. The use of applying the thermosetting resin solution is preferable from the viewpoint that the upper surface of the insulating layer 17a can be flatten by absorbing unevenness of the wiring layer 19a, the sealing resin 23, or the core upper layer 11a.
Thermosetting epoxy resin may be used as the thermosetting resin sheet or resin solution.
Similarly, the insulating layer 17b is formed on the core lower layer 11c and the wiring layer 19b.

Then, a conductive layer is formed on the insulating layer 17a, and a wiring pattern is formed on the conductive layer, thereby forming the wiring layer 19c. The conductive layer may be formed in the same manner as the conductive layers 40a and 40b. Similarly, the wiring layer 19d is formed on the insulating layer 17b.

Then, the via 16d is formed to pass through the insulating layer 17a and to electrically connect the wiring layer 19c and the wiring layer 19a to each other. Similarly, the via 16e is formed to pass through the insulating layer 17b and to electrically connect the wiring layer 19b and the wiring layer 19d. The via 16d and the via 16e may be formed in the same manner as the via 16b.

Then, the solder resist layer 18a is formed on the insulating layer 17a and the wiring layer 19c such that portions corresponding to the external connection terminal 21 are exposed, and a plating process is performed on the exposed portions, thereby forming the external connection terminal 21. For example, an NiAu plating process may be used as the plating process. Similarly, the solder resist layer 18b and the external connection terminal 21 are formed on the insulating layer 17b and the wiring layer 19d, thereby obtaining the electronic component package 10 shown in Fig. 1.

According to the above-described embodiment, the electrode pads 20 and the terminals 21 can be securely electrically connected to each other by the bonding wires 13 in consideration of the position of the electronic component 30 disposed in the hollow portion 14. Since high precision is not required at the time of disposing the electronic component 30 in the hollow portion 14, it is easy to produce the electronic component package 10.
Since inferior goods can be removed in the process by checking electrical connection among the bonding wires 13, the electrode pads 20, and the electronic component 30, it is possible to manufacture the electronic component package 10 to which the electronic component 30 is securely electrically connected.

The electronic component package and the method for manufacturing the same are not limited to the above-described exemplary embodiments, and may be appropriately modified without departing from the technical scope of the present invention.
In the above-described embodiment, one electronic component 30 is mounted, but, for example, two or more hollow portions may be formed and two or more electronic components may be disposed and fixed therein, respectively.

In the above-described embodiment, the wiring boards are laminated on an upper surface and a lower surface of the core layer 11, but the wiring boards may be laminated on the upper surface or the lower surface of the core layer 11. In addition, only one wiring board may be laminated on the upper surface or the lower surface of the core layer 11.

In the above-described embodiment, the multi-layered wiring board including the wiring layer 19a, the insulating layer 17a, and the wiring layer 19c is laminated on the upper surface of the core layer 11, but a multi-layered wiring board including a larger number of insulating layers and wiring layers may be laminated on the upper surface of the core layer 11. The same may applied to the multi-layered wiring board laminated on the lower surface of the core layer 11.

In the above-described embodiment, in addition to the thermosetting resin, photocurable resin may be used.

According to exemplary embodiments of the present invention, a pass/fail test of electrical characteristics can be conducted every solder ball mounting target area of the large-size substrate, and also the mounting can be performed only in the good area by skipping the defective area. Therefore, the useless mounting process can be omitted.

## Claims

1. An electronic component package (10) comprising:
a core layer (11) including a plurality of insulating layers formed by impregnating a base material with a resin, wherein a hollow portion (14) is formed in the core layer;
core wiring layers (12a, 12b) each disposed between the insulating layers; and
an electronic component (30) disposed in the hollow portion,
wherein the electronic component and the core wiring layer are electrically connected to each other by a bonding wire.

2. The electronic component package according to Claim **1**, wherein the core layer includes:
an insulating core intermediate layer (11b) having an intermediate-layer through-hole (15b) constituting the hollow portion, wherein the electronic component is housed in the intermediate-layer through-hole;
an insulating core lower layer (11c) disposed on a lower surface of the insulating core intermediate layer, wherein the electronic component is bonded onto the insulating core lower layer; and
an insulating core upper layer (11a) disposed on an upper surface of the insulating core intermediate layer and having an upper-layer through-hole (15a) constituting the hollow portion together with the intermediate-layer through-hole (15b),
wherein the core wiring layers includes:
an upper core wiring layer (12a) formed on the upper surface of the insulating core intermediate layer; and
an lower core wiring layer (12b) formed on the lower surface of the insulating core intermediate layer,
wherein the upper-layer through-hole is larger than the intermediate-layer through-hole, and
wherein the electronic component are electrically connected to the upper core wiring layer exposed from the insulating core upper layer, by the bonding wire (13).

3. The electronic component package according to Claim **2**, wherein the insulating core intermediate layer includes:
a via passing (16b) through the core intermediate layer (11b), wherein the upper core wiring layer and the lower core wiring layer are electrically connected to each other by the via, and
wherein an aspect ratio of the via is 1 or less.

4. The electronic component package according to one of the Claims **1 to 3**, wherein the hollow portion in which the electronic component is disposed is filled with a sealing material (23).

5. The electronic component package according to one of the Claims **1 to 4**, wherein at least one wiring board (17a, 17b, 19a, 19b, 19c, 19d) is formed on an upper surface of the core layer or a lower surface of the core layer.

6. The electronic component package according to one of the Claims **1 to 5**, wherein the base material is made of a glass cross, and the resin is an epoxy resin.

7. A method of manufacturing an electronic component package, the method comprising:
(a) providing a first insulating layer formed by impregnating a base material with a resin;
(b) forming conductive layers on upper and lower surfaces of the first insulating layer;
(c) forming a through-hole in the first insulating layer;
(d) forming a via in the through-hole;
(e) forming wiring patterns on the conductive layer formed on the upper surface of the first insulating layer;
(f) forming a first opening in the first insulating layer;
(g) patterning the conductive layers, thereby forming wiring layers;
(h) forming a second insulating layer, formed by impregnating a base material with a resin, on the upper surface of the first insulating layer;
(i) forming a second opening in the second insulating layer such that the second opening is larger than the first opening and such that a center of the second opening coincides with that of the first opening;
(j) forming a third insulating layer, formed by impregnating a base material with a resin, on the lower surface of the first insulating layer;
(k) heating and pressurizing the first insulating layer, the second insulating layer and the third insulating layer, thereby integrating the first insulating layer, the second insulating layer and the third insulating layer;
(l) housing an electronic component in the first opening such that the electronic component is mounted on the third insulating layer exposed from the second insulating layer; and
(m) electrically connecting the electronic component to the wiring layer formed on the upper surface of the first insulating layer, by a bonding wire.
